# FASCICULE DE BREVET EUROPEEN

(11) **EP 3 494 594 B1**
(45) Date de publication et mention de la délivrance du brevet: **13.05.2020**
(21) Numéro de dépôt: 17765214.6
(22) Date de dépôt: 28.07.2017
(51) Int. Cl.: H01L 23/043, H01L 23/00, H01L 21/48, H01L 21/56, H01L 23/367, H01L 23/051, H01L 23/13, H01L 23/15, H01L 23/373

(54) **PROCÉDÉ DE FABRICATION D'UN MODULE DE PUISSANCE TRIDIMENSIONNEL**
HERSTELLUNGSVERFAHREN EINES DREIDIMENSIONALEN LEISTUNGSMODULS
FABRICATION PROCESS OF A THREE-DIMENSIONAL POWER MODULE

(30) Priorité: 05.08.2016 FR 1657602
(43) Date de publication de la demande: 12.06.2019
(73) Titulaire: Commissariat à l'Énergie Atomique et aux Énergies Alternatives, 75015 Paris (FR)
(72) Inventeur: MARCAULT, Emmanuel, 28330 La Bazoche-Gouet (FR); CIGNA, Jean-Charles, 31400 Toulouse (FR)
(74) Mandataire: Guérin, Jean-Philippe
(86) Numéro de dépôt international: PCT/FR2017/052141
(87) Numéro de publication internationale: WO 2018/024973

(56) Documents cités:
- US-A- 5 608 610
- US-A1- 2001 002 729
- US-A1- 2014 117 473
- US-A1- 2014 307 390
- US-A1- 2015 357 258
- US-A1- 2016 064 302

## Description

L'invention concerne les modules de puissance tridimensionnels, et en particulier les procédés de fabrication de tels modules de puissance.

Un module de puissance est un élément dont le fonctionnement s'assimile à celui d'un ou plusieurs interrupteurs. Sa structure est généralement constituée de l'association de différents éléments :
- des puces incluant un composant semi-conducteur assurant la fonction commutation électrique ;
- un substrat isolant permettant à la fois l'isolation électrique et le transfert du flux de chaleur dissipée par les puces ;
- une semelle pour une liaison à un dissipateur thermique ;
- un encapsulant ;
- un boîtier ;
- des connexions électriques internes et externes ;
- parfois des capacités de découplage.

L'augmentation des températures de fonctionnement est une des évolutions actuelles de l'électronique de puissance. Les puces à composants en silicium sont limitées par une température de jonction maximale généralement comprise entre 125 et 200°C, ce qui freine le développement des applications hautes températures. En outre, la tension de claquage d'un composant en Silicium est limitée et ses pertes de commutation à haute fréquence sont élevées. Ce type d'application concerne des domaines aussi variés que l'aéronautique civile et militaire, la traction ferroviaire, l'automobile, la distribution énergétique, le forage pétrolier terrestre et maritime, la recherche géothermale, ou le spatial.

Pour des applications haute tension et/ou haute fréquence, des puces à transistors à hétérojonction, et incluant en particulier des transistors à haute mobilité électronique à nitrure de type III, sont utilisées de façon croissante.

Un des enjeux majeurs de l'électronique de puissance pour la montée en température, en tension ou en fréquence des modules de puissance est la disponibilité de techniques d'encapsulation fiables de différentes puces et composants, assurant à la fois l'interconnexion électrique des composants semiconducteurs, l'évacuation de la chaleur générée par ces composants et parfois la tenue mécanique du module.

Outre le semiconducteur des composants, des limitations en performances électriques, en montée en température et en fiabilité des composants et modules de puissance, proviennent des matériaux de leur encapsulation. L'une des limites majeures est la création de contraintes thermomécaniques liées à la différence de coefficient de dilatation des matériaux lors d'une variation de température.

De nouveaux concepts d'encapsulation proposent de réaliser une structure tridimensionnelle, notamment en vue de refroidir le module encapsulé par deux faces et en vue de réduire l'encombrement en surface du module.

La thèse de M. Bassem Mouawad, publiée sous l'intitulé « assemblages innovants en électronique de puissance utilisant la technique de « Spark Plasma Sintering » », décrit un exemple de procédé d'encapsulation d'un module. Dans cet exemple, deux substrats à base céramique à cuivre lié directement sont fournis. Chaque substrat à base céramique comporte une face munie d'une couche de cuivre mise en forme selon un motif bidimensionnel et selon un motif dans son épaisseur. Les motifs dans l'épaisseur définissent notamment trois plots. Un premier plot est destiné à se fixer sur une puce, des deuxième et troisième plots sont destinés à se fixer à des plots de la couche de cuivre de l'autre substrat à base céramique, positionné en vis-à-vis. Par brasure, on fixe le premier plot de chaque couche de cuivre à une face respective de la puce, et on fixe mutuellement les deuxièmes plots et les troisièmes plots de ces couches de cuivre en vis-à-vis. L'association des deuxièmes et troisièmes plots des deux substrats forme une structure permettant de reprendre des efforts de compression appliqués transversalement sur les substrats.

La définition d'un motif dans l'épaisseur de la couche de cuivre s'avère complexe et coûteuse. Par ailleurs, le positionnement relatif entre les substrats, et entre le module et les substrats s'avère délicat avec un niveau de précision suffisant.

US2016064302 décrit un module semiconducteur utilisant une soudure sur plot améliorant la capacité de refroidissement. Le module semiconducteur inclut un élément semiconducteur, un plot connecté électriquement et thermiquement à une surface supérieure de l'élément semiconducteur, un substrat isolant de câblage de plots présentant des premier et deuxième films sur les surfaces avant et arrière de ce substrat. Le premier film est soudé au plot. Un premier substrat céramique présente des troisième et quatrième films métalliques disposés respectivement sur les surfaces arrière et avant de ce substrat céramique. Le troisième film métallique est soudé à la surface inférieure de l'élément semiconducteur. Des radiateurs sont connectés aux deuxième et quatrième films.

US2015357258 décrit un diffuseur de chaleur à composants multiples présentant un composant supérieur ayant une première surface et une deuxième surface opposée ayant soit une cavité ménagée dans cette deuxième surface ou une saillie s'étendant depuis la deuxième surface. Le diffuseur de chaleur comprend en outre un composant additionnel, tel qu'un piètement ou un espaceur, ayant une première surface et une deuxième surface opposée, ayant soit une cavité ménagée dans cette deuxième surface ou une saillie s'étendant depuis la deuxième surface, en opposition avec la cavité ou la saillie du composant supérieur. Le composant inférieur est attaché au composant supérieur par brasure, en mettant en regard la cavité/saillie du composant supérieur avec la cavité/saillie du composant inférieur.

US2001002729 décrit un système de radiateur amélioré. Ce radiateur est supporté physiquement par une embase plutôt que par un circuit intégré. Un tel radiateur permet d'éviter les contraintes entre le radiateur et le circuit imprimé, potentiellement destructrices de ce circuit imprimé. L'invention propose des fonctions d'alignement et de support à distance du contact avec le circuit intégré, fournissant ainsi un support de radiateur n'induisant pas de contraintes significatives dans le circuit intégré.

L'invention vise à résoudre un ou plusieurs de ces inconvénients. L'invention porte ainsi sur un procédé d'encapsulation d'un circuit intégré, tel que défini dans la revendication 1 annexée.

L'invention porte également sur les variantes définies dans les revendications dépendantes. L'homme du métier comprendra que chacune des caractéristiques des variantes des revendications dépendantes peut être combinée indépendamment aux caractéristiques de la revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- les figures 1 à 4 sont des vues en coupe transversale d'un support de circuit intégré à différentes étapes d'un exemple de procédé de fabrication;
- la figure 5 est une vue de dessus du support de circuit intégré à une autre étape d'un exemple de procédé de fabrication ;
- la figure 6 est une vue en perspective du support de circuit intégré de la figure 4 ;
- la figure 7 est une vue en coupe transversale d'un autre support du circuit intégré à une étape d'un exemple de procédé de fabrication ;
- la figure 8 est une vue de dessous du support de la figure 7 ;
- les figures 9 et 10 sont des vues en coupe transversale d'un circuit intégré à différentes étapes d'un exemple de procédé d'encapsulation selon l'invention ;
- la figure 11 est une vue en perspective du circuit intégré à l'issue du procédé d'encapsulation ;
- la figure 12 est une vue en coupe transversale d'une variante de circuit intégré à une étape d'un autre exemple de procédé d'encapsulation selon l'invention ;
- les figures 13 à 16 sont des vues en perspective de différents exemples de formes de reliefs mâles en vue de positionner les supports l'un par rapport à l'autre.

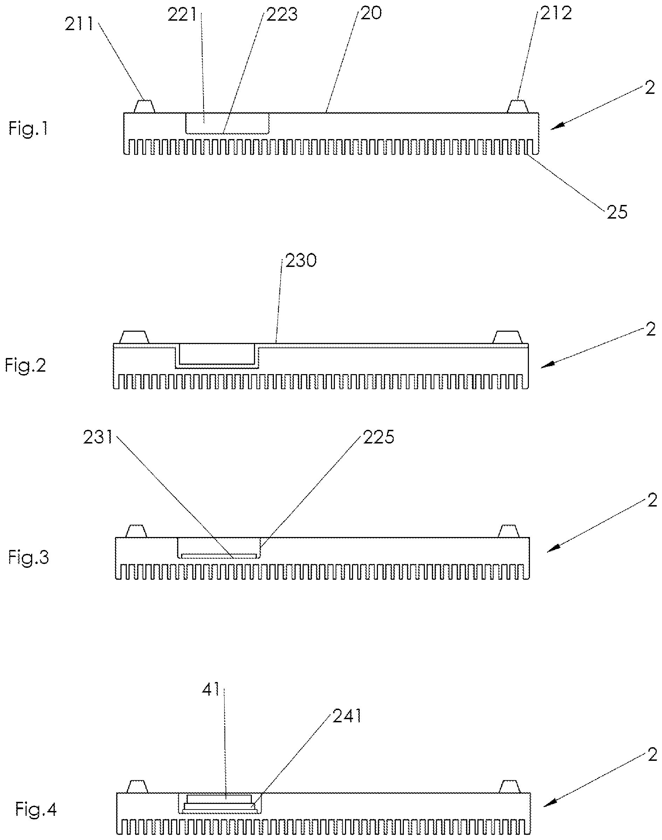

La figure 1 est une vue en coupe transversale d'un premier support 2 de circuit intégré 1, lors d'une étape de son procédé de fabrication. Par exemple par une impression tridimensionnelle ou par un moulage par injection de poudre d'un matériau diélectrique, le support 2 est formé. Le support 2, ainsi formé (par exemple et non limitativement par impression tridimensionnelle ou par moulage par injection de poudre), présente une surface plane 20 au niveau de sa face supérieure. Un renfoncement 221 est formé en retrait par rapport à la surface plane 20. Un autre renfoncement 222 (illustré ultérieurement) est également formé en retrait par rapport à la surface plane 20. Des premier et deuxième reliefs 211 et 212 sont formés par rapport à la surface plane 20. Les reliefs 211 et 212 sont positionnés à des emplacements différents du support 2. Les reliefs 211 et 212 sont ici des plots formés en saillie par rapport à la surface plane 20. Le support 2 est formé d'un seul tenant lors de l'impression tridimensionnelle ou lors du moulage par injection de poudre. Lors de l'impression tridimensionnelle ou lors du moulage par injection de poudre, on forme avantageusement des ailettes de refroidissement 25 au niveau de la face inférieure du support 2.

Les premier et deuxième reliefs 211 et 212 peuvent être formés d'une céramique sélectionnée (de manière non-exhaustive) dans le groupe constitué de ;
- le nitrure d'aluminium
- Le nitrure de Bore
- Le nitrure de Silicium
- l'alumine (ou oxyde d'aluminium)

La formation pourra être mise en œuvre par impression tridimensionnelle ou par moulage par injection de poudre d'une telle céramique.

On notera que ces céramiques peuvent être plus ou moins chargées afin de modifier leurs propriétés physiques.

À la figure 2, on réalise une métallisation de la face supérieure du support 2, de façon à métalliser au moins le fond 223 du renfoncement 221 et le fond du renfoncement 222 avec une couche de métal 230. La métallisation de cette face supérieure est par exemple réalisée pleine plaque, de sorte que la couche de métal 230 recouvre ici les reliefs 211 et 212, ainsi que la surface plane 20. Une métallisation pleine plaque peut par exemple être réalisée par PVD. Les dépôts couches-minces (PVD) appliqués sur la céramique peuvent être par exemple:
- Ti/Pt/Au
- Cr/Ni/Au
- NiCr/Au
- Argent, cuivre, ou AuSn.

Une métallisation peut aussi être réalisée par exemple par liaison directe de cuivre, par exemple pleine plaque. D'autres renfoncements et d'autres reliefs peuvent également être formés lors de l'impression tridimensionnelle ou lors du moulage par injection de poudre du support 2 mais ne seront pas davantage détaillés.

À la figure 3, on réalise une mise en forme de la couche de métal 230, pour délimiter un contact métallique 231 sur le fond 223 du renfoncement 221. La mise en forme de la couche de métal 230 peut également servir à définir des pistes conductrices sur la surface plane 20, par exemple pour créer des connexions électriques. La mise en forme de la couche de métal 230 peut par exemple être mise en œuvre par des étapes de photolithographie et de gravure, de façon connue en soi. La mise en forme de la couche de métal 230 vise notamment à retirer la majeure partie de la couche 230 de la surface plane 20, et des reliefs 211 et 212. La couche 230 est retirée des parois latérales 225 du renfoncement 221 mais une partie de la couche 230 peut être conservée sur une paroi latérale 225 du renfoncement 221 pour former une connexion avec le contact métallique 231. De façon similaire, la mise en forme de la couche de métal 230 peut délimiter le contact métallique 232 sur le fond du renfoncement 222.

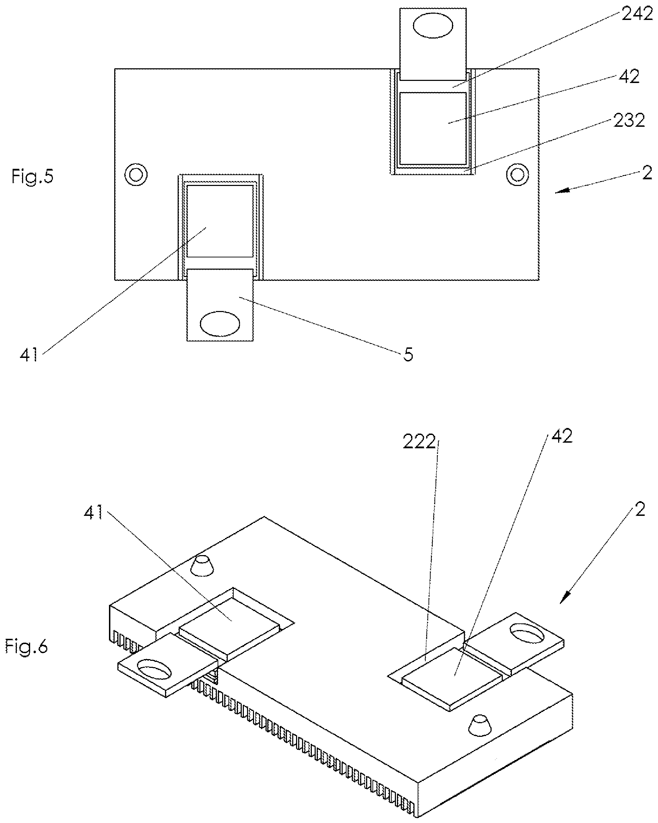

À la figure 4, on a déposé une pâte de brasage 241 sur le contact métallique 231. Additionnellement, on a déposé une pâte de brasage 242 (illustrée à la figure 5) sur le contact métallique 232.

Comme illustré aux figures 5 et 6, on a ensuite positionné une puce 41 en contact avec la pâte de brasage 241 au fond du renfoncement 221. Une électrode de la puce 41 est par exemple placée en contact avec la pâte de brasage 241, par exemple une électrode de polarisation d'un substrat de la puce 41. Une connexion électrique est ainsi formée entre une électrode de la puce 41 et le contact 231. Par ailleurs, on a avantageusement positionné un connecteur de puissance 5 contre la pâte de brasage 241, sur le côté de la puce 41, et en porte-à-faux par rapport à un bord latéral du support 2. Par une étape de brasage, on a fixé la puce 41 au contact 231, par l'intermédiaire de la pâte de brasage 241. Par une étape de brasage, on a également fixé le connecteur de puissance 5 au contact 231, par l'intermédiaire de la pâte de brasage 241. Additionnellement, on a ici positionné une puce 42 en contact avec une pâte de brasage 242 au fond de l'autre renfoncement 222. Une électrode de la puce 42 est par exemple placée en contact avec la pâte de brasage 242, par exemple une électrode de polarisation d'un substrat de la puce 42. Par une étape de brasage, on a fixé la puce 42 au contact 232, par l'intermédiaire de la pâte de brasage 242.

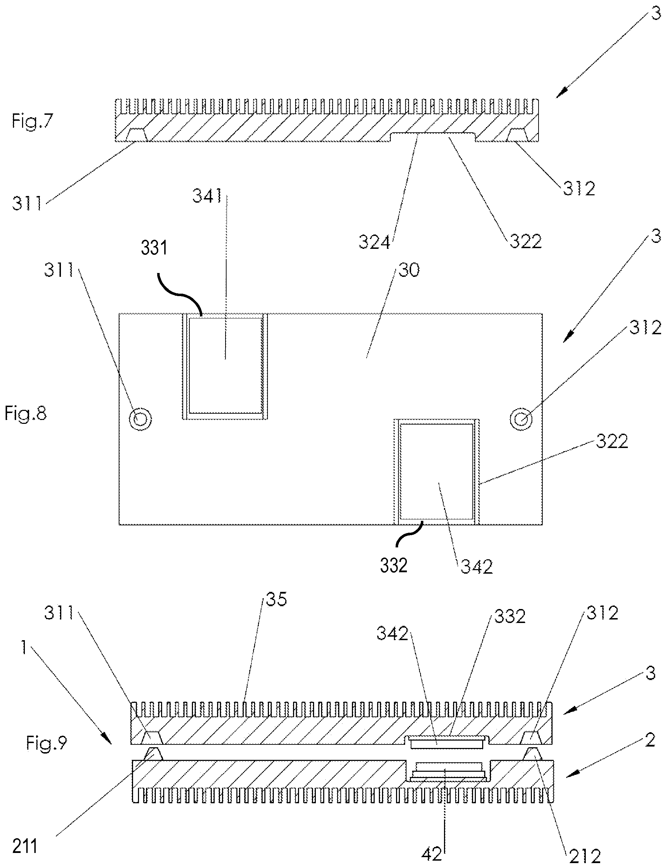

Par exemple par une impression tridimensionnelle ou par moulage par injection de poudre d'un matériau diélectrique, un autre support 3 de circuit intégré 1 est formé. Le support 3 peut alors présenter la géométrie illustrée aux figures 7 et 8. Le support 3, ainsi formé (par exemple et non limitativement par impression tridimensionnelle ou par moulage par injection de poudre), présente une surface plane au niveau de sa face inférieure. Un renfoncement 321 est formé en retrait par rapport à la surface plane 30. Un autre renfoncement 322 est formé en retrait par rapport à la surface plane 30. Des premiers et deuxièmes reliefs 311 et 312 sont formés par rapport à la surface plane 30. Les reliefs 311 et 312 sont positionnés à des emplacements différents du support 3. Les reliefs 311 et 312 sont ici des alésages en retrait par rapport à la surface plane 30. Les reliefs 311 et 312 présentent par exemple une forme complémentaire de celle des reliefs 211 et 212, ou sont configurés pour pouvoir loger la majeure partie des reliefs 211 et 212. Le support 3 est formé d'un seul tenant lors de l'impression tridimensionnelle ou lors du moulage par injection de poudre. Lors de l'impression tridimensionnelle ou lors du moulage par injection de poudre, on forme avantageusement des ailettes de refroidissement 35 au niveau de la face supérieure du support 3.

L'impression tridimensionnelle ou le moulage par injection de poudre peut être réalisé le cas échéant par impression ou moulage par injection de poudre d'une céramique sélectionnée dans le groupe constitué de de Al₂O₃, AIN, BeOx ou tout autre matériau présentant des propriétés d'isolant électrique et idéalement de bonnes propriétés de conducteur thermique.

On a réalisé une métallisation de la face inférieure du support 3, de façon à métalliser au moins le fond du renfoncement 321 avec une couche de métal. La métallisation de cette face inférieure est par exemple réalisée pleine plaque, de sorte que la couche de métal recouvre initialement les reliefs 311 et 312, ainsi que la surface plane 20. Une métallisation pleine plaque peut par exemple être réalisée par PVD sur un matériau céramique formé lors de l'impression tridimensionnelle ou lors du moulage par injection de poudre. Les dépôts couches-minces (PVD) appliqués sur la céramique peuvent être par exemple:
- Ti/Pt/Au
- Cr/Ni/Au
- NiCr/Au
- Argent, cuivre, ou AuSn.

D'autres renfoncements et d'autres reliefs peuvent également être formés lors de l'impression tridimensionnelle ou lors du moulage par injection de poudre du support 3 mais ne seront pas davantage détaillés.

On a réalisé une mise en forme de la couche de métal, pour délimiter un contact métallique 331 sur le fond du renfoncement 321, et pour délimiter un contact métallique 332 sur le fond 324 du renfoncement 322. La mise en forme de la couche de métal peut également servir à définir des pistes conductrices sur la surface plane 30, par exemple pour créer des connexions électriques. La mise en forme de la couche de métal peut par exemple être mise en œuvre par des étapes de photolithographie et de gravure, de façon connue en soi. La mise en forme de la couche de métal du support 3 vise notamment à retirer la majeure partie de cette couche de la surface plane 30, et des reliefs 311 et 312. La couche de métal est retirée des parois latérales du renfoncement 321 et du renfoncement 322, mais une partie de la couche de métal peut être conservée sur une paroi latérale /plan incliné du renfoncement 321 et/ou du renfoncement 322, pour former une connexion avec le contact métallique 331 ou avec le contact métallique 332 le cas échéant.

Lors d'une étape du procédé d'encapsulation illustrée à la figure 9, les supports 2 et 3 sont positionnés en vis-à-vis, de sorte que la surface inférieure du support 3 fasse face à la surface supérieure du support 2. Les surfaces planes 20 et 30 sont positionnées parallèles l'une par rapport à l'autre. Les reliefs 311 et 312 sont positionnés en vis-à-vis des reliefs 211 et 212 respectivement. Les renfoncements 221 et 222 sont positionnés en vis-à-vis des renfoncements 321 et 322 respectivement. La pâte à braser 341 est alors positionnée à l'aplomb d'une électrode supérieure de la puce 41. La pâte à braser 342 est alors positionnée à l'aplomb d'une électrode supérieure de la puce 42.

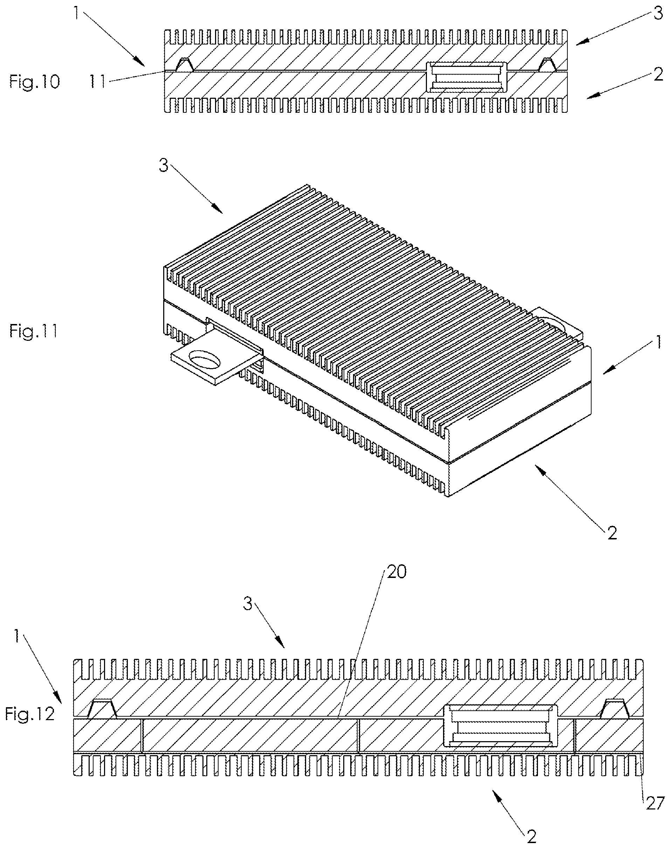

Lors de l'étape du procédé d'encapsulation illustrée à la figure 10, on fait coulisser le support 2 et le support 3 l'un par rapport à l'autre selon une direction transversale, c'est-à-dire une direction perpendiculaire à leurs surfaces planes 20 et 30, de façon à les rapprocher. Les reliefs 211 et 212 du support 2 coopèrent alors avec les reliefs 311 et 312 du support 3 pour les guider en coulissement l'un par rapport à l'autre selon la direction transversale.

Le coulissement relatif entre les supports 2 et 3 est poursuivi jusqu'à amener la pâte à braser 341 en contact avec la puce 41 et jusqu'à amener la pâte à braser 342 en contact avec la puce 42. Durant ce coulissement, la coopération entre les reliefs 211, 212 et 311, 312 permet de garantir le positionnement relatif entre les pâtes à braser 341 et 342 d'une part, et les puces 41 et 42 d'autre part, en empêchant un pivotement relatif des supports 2 et 3 par rapport à une direction normale aux surfaces planes 20 et 30, et en empêchant un coulissement relatif des supports 2 et 3 selon une direction parallèle aux surfaces planes 20 et 30.

Le circuit intégré 1 obtenu à ce stade est avantageusement conçu pour qu'un espace 11 soit ménagé entre les supports 2 et 3 lorsque la pâte à braser 341 atteint le contact avec la puce 41 et lorsque la pâte à braser 342 atteint le contact avec la puce 42. On limite ainsi les risques de fluage excessif des pâtes à braser 341 et 342 lors d'étapes ultérieures, et on permet une injection ultérieure d'une résine ou d'un matériau diélectrique entre les supports 2 et 3 et autour des puces 41 et 42.

Une fois les pâtes à braser 341 et 342 en contact respectivement avec des électrodes supérieures respectives des puces 41 et 42, on réalise le brasage des pâtes à braser 341 et 342 avec ces puces 41 et 42. On forme ainsi une fixation des puces 41 et 42 au support 3, ainsi qu'une connexion électrique entre les électrodes supérieures des puces 41 et 42 avec les contacts électriques 331 et 332 respectivement.

La figure 11 illustre une vue en perspective du circuit intégré 1 à l'issue de l'étape de brasage. Le procédé d'encapsulation peut se poursuivre par l'injection d'un matériau d'encapsulation entre les supports 2 et 3, par exemple par l'intermédiaire de l'espace 11. Le matériau d'encapsulation injecté est un matériau diélectrique, typiquement une résine époxyde ou une mousse d'encapsulation.

Le circuit intégré 1 obtenu à l'issue du procédé d'encapsulation présente un refroidissement amélioré, les faces externes des supports 2 et 3 contribuant au refroidissement. Ce refroidissement est encore amélioré dans l'exemple illustré, du fait de la présence des ailettes de refroidissement respectives 25 et 35 sur les faces externes des supports 2 et 3 respectivement.

Par ailleurs, un tel circuit intégré 1 ainsi obtenu peut présenter un encombrement plus réduit dans le plan des surfaces planes 20 et 30, des pistes conductrices pouvant notamment être réparties entre les supports 2 et 3.

Dans l'exemple illustré, les renfoncements des supports 2 et 3 présentent des parois latérales (par exemple la paroi latérale 225) sensiblement verticales. On peut également envisager qu'une ou plusieurs des parois latérales des renfoncements soit inclinées par rapport à la normale aux surfaces planes 20 ou 30. En particulier, les parois latérales destinées à recevoir un dépôt métallique s'étendant d'une des surfaces planes 20 ou 30 jusqu'à une paroi de fond du renfoncement présenteront avantageusement une telle inclinaison pour faciliter la tenue de la métallisation et l'insertion d'une puce dans le renfoncement.

La figure 12 est une vue en coupe transversale d'une variante du circuit intégré 1. Cette variante de circuit intégré 1 diffère de celle illustrée à la figure 10 uniquement par la structure de son support 2. Le support 2 comporte ici un canal 27 débouchant au niveau de la surface plane 20. Le canal 27 communique par ailleurs avec une entrée, ici ménagée sur un bord latéral du support 2. Le canal 27 peut être utilisé à l'issue de la configuration obtenue à la figure 10. Le canal 27 peut alors être utilisé pour injecter le matériau d'encapsulation dans l'espace 11.

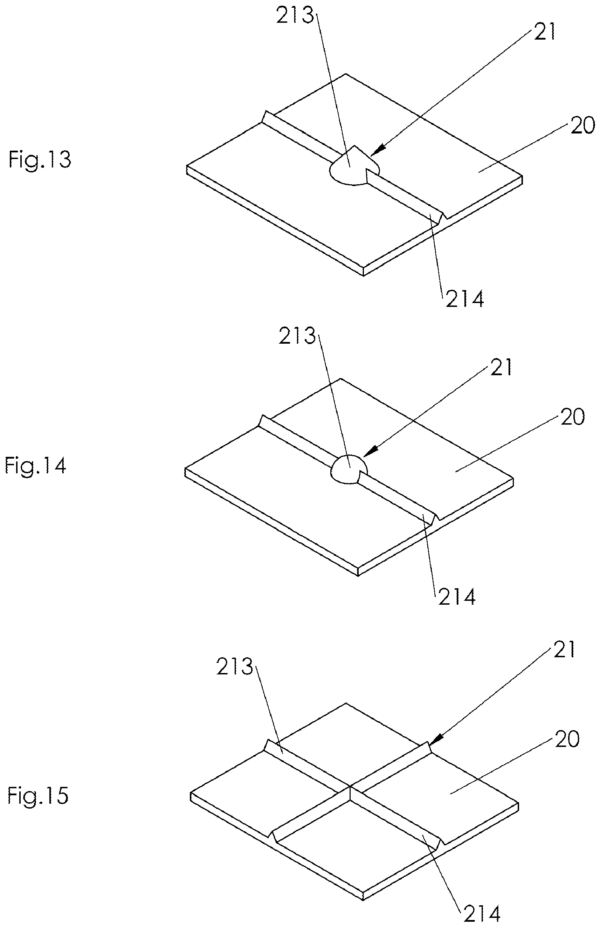

Les figures 13 à 16 illustrent à titre d'exemple différentes variantes de reliefs mâles, pouvant être formés sur un des supports 2 ou 3, en vue de favoriser son guidage par rapport à l'autre support. Dans les exemples des figures 13 à 16, les reliefs illustrés sont des reliefs mâles formés sur le support 2. Le ou les reliefs mâles peuvent également être ménagés sur le support 3 et coopérer avec des reliefs femelles du support 2.

Les reliefs mâles des figures 13 à 16 présentent avantageusement une section décroissante lorsqu'on s'éloigne de leur surface plane 20, de sorte qu'ils s'insèrent aisément dans les reliefs femelles du support 3, avant de favoriser le guidage en coulissement et le centrage par rapport à ces reliefs femelles, lorsqu'on poursuit le coulissement.

A la figure 13, le relief 21 comporte un cône 213 et un renflement de section triangulaire 214. Le renflement 214 traverse ici le cône 213 et présente une hauteur moindre par rapport au cône 213. Le cône 213 peut présenter davantage une fonction de centrage par rapport à un relief femelle, le renflement 214 pouvant présenter une fonction de verrouillage face à des pivotements relatifs des supports 2 et 3 autour d'une direction normale à la surface plane 20. On peut également prévoir que le renflement 214 ne pénètre pas dans un relief femelle du support 3. Le renflement 214 peut alors servir de butée pour la surface plane 30, et ainsi maintenir une valeur calibrée de l'espace 11, du fait de sa hauteur moindre par rapport au cône 213.

A la figure 14, le relief 21 comporte une forme hémisphérique 213 et un renflement de section triangulaire 214. Le renflement 214 traverse ici l'hémisphère 213 et présente une hauteur moindre par rapport à cet hémisphère 213. L'hémisphère 213 peut présenter davantage une fonction de centrage par rapport à un relief femelle, le renflement 214 pouvant présenter une fonction de verrouillage face à des pivotements relatifs des supports 2 et 3 autour d'une direction normale à la surface plane 20. On peut également prévoir que le renflement 214 ne pénètre pas dans un relief femelle du support 3. Le renflement 214 peut alors servir de butée pour la surface plane 30, et ainsi maintenir une valeur calibrée de l'espace 11, du fait de sa hauteur moindre par rapport à l'hémisphère 214.

A la figure 15, le relief 21 comporte des renflements 213 et 214 de section triangulaire et orientés selon des directions perpendiculaires. Les renflements peuvent coopérer avec des reliefs femelles du support 3 pour verrouiller un pivotement relatif des supports 2 et 3 autour d'une direction normale à la surface plane 20.

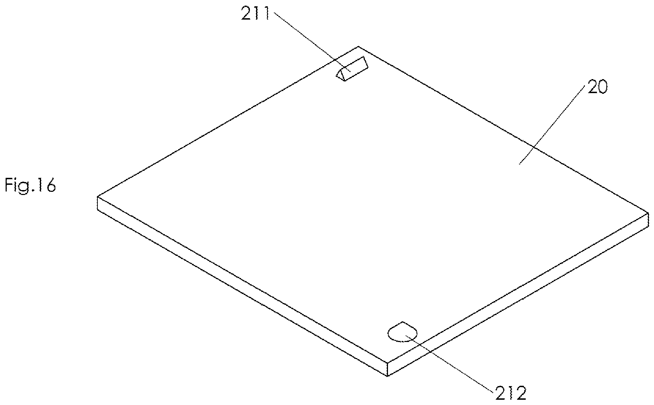

A la figure 16, deux reliefs 211 et 212 de formes différentes ont été ménagés sur la surface plane 20, avec respectivement une forme de renflement de section triangulaire, et une forme de cône.

L'invention s'applique avantageusement à un circuit intégré 1, dans lequel au moins une des puces fixées inclut un composant de puissance ou présentant une tension de claquage élevée (typiquement plusieurs centaines de Volts). Le circuit intégré 1 comprend par exemple une puce 41 incluant un transistor à hétérojonction.

La pâte à braser illustrée dans les exemples précédents se présente sous la forme d'une couche. On peut également envisager de déposer la pâte à braser sous forme de plots dissociés, de façon à réduire les risques de fluage de cette pâte à braser au-delà de renfoncements dans lesquels elle est initialement positionnée.

Selon une variante, un des supports peut être réalisé par impression tridimensionnelle ou moulage par injection de poudre initial d'un matériau conducteur, suivie d'un dépôt d'un matériau isolant pour recouvrir ce matériau conducteur. L'isolation au niveau des faces planes des supports peut être formée par un dépôt de matériau isolant autrement que par impression tridimensionnelle ou par moulage par injection de poudre.

## Revendications

1. Procédé d'encapsulation d'un circuit intégré (1), comprenant:
- la formation de premier et deuxième supports isolants électriquement (2, 3), les premier et deuxième supports formés présentant chacun une surface plane (20, 30), de façon à former un renfoncement (221) dans le premier support par rapport à sa surface plane (20), et de façon à former, par rapport à la surface plane de chacun des premier et deuxième supports, des premier (211, 311) et deuxième (212, 312) reliefs, de sorte que les premier et deuxième reliefs (211, 212) du premier (2) support coopèrent avec les premier et deuxième reliefs (311, 312) du deuxième support (3) pour guider le premier support en coulissement par rapport au deuxième support selon une direction transversale auxdites surfaces planes (20, 30) ;
- la formation d'un premier contact électrique (231) dans ledit renfoncement (221) ;
- le positionnement d'une puce (41) dans ledit renfoncement et la formation d'un contact électrique entre une première électrode de la puce (41) et ledit premier contact électrique (231) ;
- la formation d'un deuxième contact électrique (331) sur ledit deuxième support (3) et le dépôt d'un matériau de brasage (241) sur ledit deuxième contact électrique;
- la superposition des premier et deuxième supports (2, 3) de façon à superposer leurs premiers et deuxièmes reliefs respectifs et de façon à positionner le matériau de brasage (241) à l'aplomb d'une deuxième électrode de ladite puce (41) ;
- le coulissement du premier support (2) selon ladite direction transversale par rapport au deuxième support (3) jusqu'à amener le matériau de brasage (241) en contact avec la deuxième électrode de la puce ;
- le brasage du matériau de brasage (241) de façon à fixer ladite puce (41) audit deuxième support (3).

2. Procédé d'encapsulation selon la revendication 1, dans lequel un espacement (10) est ménagé entre les surfaces planes (20,30) respectives des premier et deuxième supports (2, 3).

3. Procédé d'encapsulation selon la revendication 2, comprenant une étape d'injection d'une résine isolante électriquement dans ledit espacement (10).

4. Procédé d'encapsulation selon l'une quelconque des revendications 1 à 3, dans lequel la formation de premier et deuxième supports isolants électriquement (2, 3) inclut une impression tridimensionnelle ou un moulage par injection de poudre.

5. Procédé d'encapsulation selon la revendication 4, dans lequel ladite formation de premier et deuxième supports isolants électriquement inclut la formation d'un canal (27) à l'intérieur du premier ou du deuxième support, ce canal débouchant sur ladite surface plane (20) de ce support, ladite étape d'injection de la résine isolante incluant l'injection de ladite résine isolante par l'intermédiaire dudit canal (27).

6. Procédé d'encapsulation selon l'une quelconque des revendications précédentes, dans lequel ladite formation de premier et deuxième supports isolants électriquement inclut la formation d'une céramique sélectionnée dans le groupe constitué de Al₂O₃, AlN ou BeOx.

7. Procédé d'encapsulation selon la revendication 6, dans lequel la formation desdits premier et deuxième contacts électriques (231,331) est réalisée par liaison directe de cuivre sur ladite céramique.

8. Procédé d'encapsulation selon la revendication 6, dans lequel la formation desdits premier et deuxième contacts électriques (231,331) est réalisée par dépôt physique en phase vapeur.

9. Procédé d'encapsulation selon l'une quelconque des revendications précédentes, dans lequel ladite formation de premier et deuxième supports isolants électriquement inclut la formation d'ailettes de refroidissement (25,35) dans lesdits premier et deuxième supports (2, 3).

10. Procédé d'encapsulation selon la revendication 9, dans lequel lesdites ailettes de refroidissement (25,35) sont ménagées sur des faces desdits premier et deuxième supports opposées auxdites surfaces planes (20,30).

11. Procédé d'encapsulation selon l'une quelconque des revendications précédentes, dans lequel ladite puce (41) inclut un transistor à hétérojonction.

12. Procédé d'encapsulation selon l'une quelconque des revendications précédentes, dans lequel lesdits premiers reliefs des premier et deuxième supports présentent une forme se rétrécissant en s'éloignant de ladite surface plane.

13. Procédé d'encapsulation selon la revendication 12, dans lequel lesdits premiers reliefs formés présentent une face latérale de forme conique.

14. Procédé d'encapsulation selon la revendication 12, dans lequel lesdits premiers reliefs formés présentent une surface hémisphérique.

15. Procédé d'encapsulation selon la revendication 12, dans lequel un desdits reliefs formés présente une forme sans symétrie par rapport à un axe normal à sa surface plane.

## Patentansprüche

1. Verfahren zur Einkapselung einer integrierten Schaltung (1), umfassend:
- das Ausbilden von ersten und zweiten elektrisch isolierenden Trägern (2, 3), wobei jeder der ersten und zweiten ausgebildeten Träger eine ebene Oberfläche (20, 30) aufweist, so dass eine Vertiefung (221) in dem ersten Träger in Bezug auf seine ebene Oberfläche (20) ausgebildet wird und so, dass in Bezug auf die ebene Oberfläche jedes der ersten und zweiten Träger erste (211, 311) und zweite (212, 312) Erhebungen derart ausgebildet werden, dass die ersten und zweiten Erhebungen (211, 212) des ersten (2) Trägers mit den ersten und zweiten Erhebungen (311, 312) des zweiten Trägers (3) zusammenwirken, um den ersten Träger in Bezug auf den zweiten Träger entlang einer quer zu den ebenen Oberflächen (20, 30) verlaufenden Richtung verschieblich zu führen;
- das Ausbilden eines ersten elektrischen Kontakts (231) in der Vertiefung (221);
- das Positionieren eines Chips (41) in der Vertiefung und das Ausbilden eines elektrischen Kontakts zwischen einer ersten Elektrode des Chips (41) und dem ersten elektrischen Kontakt (231);
- das Ausbilden eines zweiten elektrischen Kontakts (331) auf dem zweiten Träger (3) und das Aufbringen eines Lötmaterials (241) auf den zweiten elektrischen Kontakt;
- das Übereinandersetzen der ersten und zweiten Träger (2, 3), so dass ihre jeweiligen ersten und zweiten Erhebungen übereinander gesetzt werden, und so, dass das Lötmaterial (241) lotrecht zu einer zweiten Elektrode des Chips (41) positioniert wird;
- das Schieben des ersten Trägers (2) entlang der quer zum zweiten Träger (3) verlaufenden Richtung, bis das Lötmaterial (241) in Kontakt mit der zweiten Elektrode des Chips gebracht ist;
- das Löten des Lötmaterials (241), so dass der Chip (41) an dem zweiten Träger (3) befestigt wird.

2. Einkapselungsverfahren nach Anspruch 1, bei dem ein Zwischenraum (10) zwischen den jeweiligen ebenen Oberflächen (20, 30) der ersten und zweiten Träger (2, 3) gebildet wird.

3. Einkapselungsverfahren nach Anspruch 2, umfassend einen Schritt des Einspritzens eines elektrisch isolierenden Harzes in den Zwischenraum (10).

4. Einkapselungsverfahren nach einem der Ansprüche 1 bis 3, bei dem das Ausbilden von ersten und zweiten elektrisch isolierenden Trägern (2, 3) ein dreidimensionales Drucken oder ein Pulver-Spritzgießen beinhaltet.

5. Einkapselungsverfahren nach Anspruch 4, bei dem das Ausbilden von ersten und zweiten elektrisch isolierenden Trägern das Ausbilden eines Kanals (27) im Inneren des ersten oder des zweiten Trägers beinhaltet, wobei dieser Kanal an der ebenen Oberfläche (20) dieses Trägers mündet, wobei der Schritt des Einspritzens des isolierenden Harzes das Einspritzen des isolierenden Harzes über den Kanal (27) beinhaltet.

6. Einkapselungsverfahren nach einem der vorhergehenden Ansprüche, bei dem das Ausbilden von ersten und zweiten elektrisch isolierenden Trägern das Ausbilden einer Keramik beinhaltet, die aus der Gruppe gewählt ist, die aus Al₂O₃, AlN oder BeOx besteht.

7. Einkapselungsverfahren nach Anspruch 6, bei dem das Ausbilden der ersten und zweiten elektrischen Kontakt (231, 331) durch direkte Kupferverbindung auf der Keramik ausgeführt wird.

8. Einkapselungsverfahren nach Anspruch 6, bei dem das Ausbilden der ersten und zweiten elektrischen Kontakte (231, 331) durch physikalische Gasphasenabscheidung ausgeführt wird.

9. Einkapselungsverfahren nach einem der vorhergehenden Ansprüche, bei dem das Ausbilden von ersten und zweiten elektrisch isolierenden Trägers das Ausbilden von Kühlrippen (25, 35) in den ersten und zweiten Trägern (2, 3) beinhaltet.

10. Einkapselungsverfahren nach Anspruch 9, bei dem die Kühlrippen (25, 35) auf Seiten des ersten und zweiten Trägers ausgebildet sind, die entgegengesetzt zu den ebenen Oberflächen (20, 30) sind.

11. Einkapselungsverfahren nach einem der vorhergehenden Ansprüche, bei dem der Chip (41) einen Heteroübergangstransistor beinhaltet.

12. Einkapselungsverfahren nach einem der vorhergehenden Ansprüche, bei dem die ersten Erhebungen der ersten und zweiten Träger eine Form aufweisen, die sich mit zunehmender Entfernung von der ebenen Oberfläche verjüngt.

13. Einkapselungsverfahren nach Anspruch 12, bei dem die ausgebildeten ersten Erhebungen eine Seitenfläche von konischer Form aufweisen.

14. Einkapselungsverfahren nach Anspruch 12, bei dem die ausgebildeten ersten Erhebungen eine halbkugelförmige Oberfläche aufweisen.

15. Einkapselungsverfahren nach Anspruch 12, bei dem eine der ausgebildeten Erhebungen eine in Bezug auf eine senkrecht zu ihrer ebenen Oberfläche verlaufenden Achse asymmetrische Form aufweist.

## Claims

1. Method for encapsulating an integrated circuit (1), comprising:
- the formation of first and second electrically insulating supports (2, 3), the first and second supports formed each having a planar surface (20, 30), so as to form a recess (221) in the first support with respect to its planar surface (20), and so as to form, with respect to the planar surface of each of the first and second supports, first (211, 311) and second (212, 312) reliefs, such that the first and second reliefs (211, 212) of the first support (2) cooperate with the first and second reliefs (311, 312) of the second support (3) to guide the first support by sliding with respect to the second support in a direction transversal to said planar surfaces (20, 30);
- the formation of a first electrical contact (231) in said recess (221);
- the positioning of a chip (41) in said recess and the formation of an electrical contact between a first electrode of the chip (41) and said first electrical contact (231);
- the formation of a second electrical contact (331) on said second support (3) and the deposition of a brazing material (241) on said second electrical contact;
- the superposing of the first and second supports (2, 3) so as to superpose their first and second respective reliefs and so as to position the brazing material (241) plumb with a second electrode of said chip (41);
- the sliding of the first support (2) in said transverse direction with respect to the second support (3) to bring the brazing material (241) into contact with the second electrode of the chip;
- the brazing of the brazing material (241) so as to fix said chip (41) to said second support (3).

2. Encapsulation method according to Claim 1, wherein a gap (10) is formed between the respective planar surfaces (20,30) of the first and second supports (2, 3).

3. Encapsulation method according to Claim 2, comprising a step of injection of an electrically insulating resin into said gap (10).

4. Encapsulation method according to any one of Claims 1 to 3, wherein the formation of first and second electrically insulating supports (2, 3) includes a three-dimensional printing or a powder injection molding.

5. Encapsulation method according to Claim 4, wherein said formation of first and second electrically insulating supports includes the formation of a channel (27) inside the first or the second support, this channel emerging on said planar surface (20) of this support, said step of injection of the insulating resin including the injection of said insulating resin via said channel (27).

6. Encapsulation method according to any one of the preceding claims, wherein said formation of first and second electrically insulating supports includes the formation of a ceramic selected from the group composed of Al₂O₃, AIN or BeOx.

7. Encapsulation method according to Claim 6, wherein the formation of said first and second electrical contacts (231,331) is performed by direct bonding of copper on said ceramic.

8. Encapsulation method according to Claim 6, wherein the formation of said first and second electrical contacts (231,331) is performed by physical vapour deposition.

9. Encapsulation method according to any one of the preceding claims, wherein said formation of first and second electrically insulating supports includes the formation of cooling fins (25,35) in said first and second supports (2, 3).

10. Encapsulation method according to Claim 9, wherein said cooling fins (25,35) are formed on faces of said first and second supports opposite said planar surfaces (20,30).

11. Encapsulation method according to any one of the preceding claims, wherein said chip (41) includes a heterojunction transistor.

12. Encapsulation method according to any one of the preceding claims, wherein said first reliefs of the first and second supports have a form that narrows with distance away from said planar surface.

13. Encapsulation method according to Claim 12, wherein said first reliefs formed have a tapered lateral face.

14. Encapsulation method according to Claim 12, wherein said first reliefs formed have a hemispherical surface.

15. Encapsulation method according to Claim 12, wherein one of said reliefs formed has a form without symmetry with respect to an axis normal to its planar surface.
